Europäisches Patentamt

European Patent Office

Office européen des brevets

(11) Publication number : **0 484 260 A2**

(12) **EUROPEAN PATENT APPLICATION**

(21) Application number : 91480147.7

(22) Date of filing : 26.09.91

(51) Int. Cl.⁵ : **H01J 29/76, H01J 37/147**

(30) Priority : 31.10.90 US 607196

(43) Date of publication of application :
06.05.92 Bulletin 92/19

(84) Designated Contracting States :
DE FR GB

(71) Applicant : **International Business Machines
Corporation
Old Orchard Road
Armonk, N.Y. 10504 (US)**

(72) Inventor : **Gaston, Charles A.
8 Saddle Rock Drive
Poughkeepsie N.Y.12603 (US)**

Inventor : **Ho, Cecil T.
12 Mockingbird Lane
Poughkeepsie N.Y.12603 (US)**
Inventor : **Langner, Guenther O.
Village Crest Apartments C-10, Rt.376 &
Maloney Rd
Poughkeepsie N.Y. 12603 (US)**
Inventor : **Petric, Paul F.
Bradley Court, Ives Farm
Brewster, New York 10509 (US)**
Inventor : **Sturans, Maris A.
12 Hagan Dr.
Essex Junction, VT 05452 (US)**

(74) Representative : **Combeau, Jacques
Compagnie IBM France Département de
Propriété Intellectuelle
F-06610 La Gaude (FR)**

(54) Compensation of mutual inductance in multi-channel deflection yokes.

(57) A method and apparatus for providing compensation for mutual inductance between co-directional coils of a multichannel yoke utilizes a transformer to impose a voltage on a slow response time driver circuit of a first coil which corresponds to the current in a second coil. The voltage deliberately coupled to the driver circuit of the first coil opposes the induced voltage in the first coil and effectively inhibits current disturbances from being induced in the driver circuit so as to prevent the slow response time driver circuit from attempting to correct such a disturbance and extending the duration of the disturbance. The improvement in settling time thus achieved allows realization of the full potential of multi-channel generation of magnetic fields, particularly as applied to charged particle beam deflection arrangements such as in cathode ray tubes and electron beam lithography devices. Utilization of the invention also allows avoidance of geometrical constraints on the relative location of coils to alter their mutual inductance.

FIG.2

EP 0 484 260 A2

## BACKGROUND OF THE INVENTION

### Field of the Invention

The present invention generally relates to systems for the electrical generation of a magnetic field and, more particularly, to arrangements for developing a high-precision, rapidly variable magnetic field-having two or more co-directional components, each component being developed by a separate coil and driver-circuit, such as in arrangements for deflecting charged particle beams.

### Description of the Prior Art

It has long been recognized that motion of charged particles such as charged droplets, ions, electrons, and sub-atomic particles, can be altered electrostatically by attracting or repelling the charge carried by the particles with an electrostatic charge in the vicinity of the path of charged particles. Ink jet printers and oscilloscopes are known devices which operate by electrostatic deflection of a beam of charged particles. If the charged particles are initially in motion, the charge carried by the particles represents a current, the direction of which also can be altered by the imposition of a magnetic field. Television picture tubes and electron beam lithography devices are typical of devices which use magnetic deflection of an electron beam. While electrostatic deflection provides high speed of deflection, magnetic deflection is often preferred for a number of design considerations such as lower aberration at comparable beam deflection angles. Arrangements for producing magnetic deflection include a means, usually a coil divided into a pair of coils disposed symmetrically about the electron optical axis of the device, for producing a uniform magnetic field in response to a current. Such means and portions thereof will be hereinafter referred to as deflection coils, yokes, drivers, etc. in the interest of clarity since such an application will be familiar to those skilled in the art. Similarly, other terms in common usage in the art (e.g. "horizontal", "vertical", etc.) in reference to common applications of deflection arrangements are also used in the interest of clarity because of their familiarity. It is to be understood that such direct or indirect references to a possible use are not intended to limit of infer limitation on the range of possible applicability of the invention.

Magnetic deflection may require the development of relatively high magnetic flux, depending on the mass and velocity of the particles, the charge thereon and the range (e.g. the distance over which the beam can be deflected at the target) of deflection required. If variation of the magnetic flux is required, it is typically developed by coils through which a modulated current, generated by a driver circuit, is passed. The electrical inductance of such a coil tends to reduce the bandwidth of the driver circuit and the precision with which the deflection of the beam can be made to follow a desired signal.

In magnetic deflection arrangements, plural deflection systems must be used to provide deflection in orthogonal directions. It is often desirable to locate the deflection coils in close proximity along the axis of the undeflected electron beam. Such physical proximity causes a mutual inductance or inductive coupling to exist among the deflection coils and, hence, among the deflection coil driver circuits. Such coupling allows changes in current in one of the deflection coils to induce a current component in the other coil, resulting in errors in the positioning of the beam. If the beam is to be deflected through a raster with repeated wave forms, distortion of the raster would occur.

Such induced currents can theoretically be kept small by designing the driver to have a very high output impedance. Also, some other interactions caused by the inductive coupling between the circuits can be dealt with by the provision of damping circuits to prevent ringing and the like, where the frequency components of the deflection signal are known, as in a device where deflection is repeated through a repeated raster. However, it is not always possible to maintain a high impedance for the coil driver circuit and it may also be desirable for other reasons to provide a low impedance driver or to shunt the driver with relatively low impedance elements.

An arrangement for correcting raster distortion of this type is taught by Davies, U. S. Patent 3,149,260, as applied to a deflection arrangement for a television camera tube. In the arrangement of Davies, a transformer primary winding is placed in series with the line wave form generator and the voltage produced on the transformer secondary winding is imposed on the field direction coil in parallel with the field generator circuit to oppose the current induced by the inductive coupling of the deflection coils. The transformer secondary voltage may be adjusted by changing the inductive coupling between primary and secondary coils of the transformer or by providing an adjustable shunt across the primary winding. Davies illustrates imposing the secondary voltage on the field generating circuit through the damping circuit but also indicates that if the field deflection generator impedance is sufficiently low to permit a current component to be produced, the transformer secondary can be placed in series with the field deflection generator.

To provide high speed deflection of an electron beam while allowing wide range, it is common to develop the magnetic field as a plurality of co-directional components, each component being produced independently by a separate coil and driver. The term "co-directional", will be used herein to mean magnetic field components which are of a direction and location to result in a deflection of a charged particle beam in generally the same direction even though the magnetic fields may not be either co-axial or components of the magnetic field which are precisely parallel. For example, a spiralling beam requires a rotational offset between two coils producing deflection in the same direction if the coils are stacked in the direction of the electron optical axis of the deflection system without an intervening lens. Such arrangements are generically referred to as multi-channel systems. The plurality of coils, when fabricated as a unit are referred to as multi-channel yokes. Multi-channel systems typically provide major and minor deflection systems including major and minor deflection coils. In such an arrangement, the first or major deflection system provides gross positioning of the beam and is typically a high current circuit having a slow response time. In a display system, for instance, major deflection might correspond to character position and minor deflection might correspond to dot positions within the character space.

The bandwidth of the circuit is also often further reduced (e.g. response or settling time increased) to provide increased noise immunity. The second or minor deflection system is typically a low current circuit of much faster response time to modify the positioning of the beam from the position resulting from the major deflection system. Theoretically, the positioning accuracy and throughput speed of such a multi-channel system should be equal to the performance of the minor deflection system, itself.

When major and minor deflection systems are used, a problem arises due to the difference in bandwidth and settling times of the two driver circuits. A difference in settling time and response speed is characteristic of major/minor magnetic systems to exploit the economy of separation of the high speed and high current requirements to theoretically independent circuits. This difference in response times is therefore unavoidable if the advantages of a major/minor deflection scheme are to be obtained. However, the circuits often cannot be maintained entirely independent of each other because of the mutual inductance between the individual coils of a multi-channel system.

Provision of separation between the major and minor deflection coils to limit mutual inductance causes difficulty due to the geometry of the coils and differences in the magnetic flux at different points within the field of the coil which increase with increasing axial separation of the coils. The effect of providing coil separation in such a degree as to significantly reduce mutual inductive coupling is to introduce position non-linearity into the deflection system which is difficult to compensate. Also, in some magnetic deflection arrangements, the major and minor deflection coils cannot be axially separated consistent with maintaining the geometrical properties of such arrangements. For instance, the Variable Axis Immersion Lens (VAIL) requires major and minor deflection coils of the correction yoke to be placed in the same axial position and, in fact, the coils are formed by windings on the same bobbin. In such a system the mutual inductance between channels is not only unavoidable, but maximized.

The mutual inductance of the deflection coils causes a change in current in one of the coils to result in a disturbance in the other. When a change in the current in a minor deflection coil induces a disturbance in a major deflection coil, the major deflection coil driver circuit will try to compensate for the disturbance. However, as indicated above, the major deflection drivers are intentionally made slow to avoid being noisy. Therefore, recovery from the disturbance will take many tens of microseconds. Such a long recovery or settling time is incompatible with obtaining the full benefits of a major/minor deflection arrangement which should allow accurate positioning of the beam within a very few microseconds or less for the magnetic deflection or magnetic deflection portion of the deflection system.

Therefore, in the present state of the art, a design trade-off remains between positioning accuracy and settling time. Accordingly, a limitation on settling time governed by the major deflection system rather than the minor deflection system prevents the potential accuracy and speed advantages of a multi-channel system from being realized.

## SUMMARY OF THE INVENTION

It is therefore an object of the present invention to provide an arrangement for reducing or eliminating an electrical disturbance in one circuit resulting from a change in current in another circuit with which it is inductively coupled.

It is another object of the invention to provide an arrangement to accurately compensate for mutual inductance between two electrical circuits of greatly differing bandwidths and/or response times.

It is a further object of the invention to provide effective isolation of magnetic deflection circuits which is independent of axial positioning of magnetic deflection coils.

It is another further object of the invention to provide an arrangement and method of modifying the net mutual inductance of two or more inductively coupled circuits.

It is yet another object of the invention to provide an extremely high speed magnetic deflection circuit having high positioning accuracy.

In order to attain the above and other objects of the invention, a method of producing a magnetic field having at least first and second co-directional components is provided including the step of applying a voltage corresponding to a current in a second coil to a first coil which has a polarity for opposing current induced in said first coil by said second current in said second coil.

In accordance with another aspect of the invention, a multichannel magnetic yoke having at least first and second coils which are inductively coupled and positioned to produce said first and second co-directional magnetic field components is provided in combination with means for developing a voltage component corresponding to a current in at least said second coil.

In accordance with another aspect of the invention, a system is provided for production of a magnetic field having at least first and second co-directional components including a multi-channel yoke including first and second coils which are inductively coupled and positioned to produce said first and second co-directional components, first and second driver circuit means connected to the first and second coils for passing first and second currents through the first and second coils, respectively, and means for imposing a voltage component corresponding to the second current on the first coil, the voltage component having a polarity such that current induced in said first coil by said second current in said second coil is opposed.

## BRIEF DESCRIPTION OF THE DRAWINGS

The foregoing and other objects, aspects and advantages will be better understood from the following detailed description of a preferred embodiment of the invention with reference to the drawings, in which:

Figure 1 is a schematic diagram of a conventional multichannel magnetic yoke and major/minor driver circuits therefor.

Figure 2 is a schematic diagram of a compensated multichannel magnetic yoke and driver circuitry corresponding to the invention.

Figures 3 and 4 are drawings of types of transformers usable with the invention.

Figures 5a, 5b, 6a, 6b, 7a and 7b are wave forms useful in understanding the invention.

## DETAILED DESCRIPTION OF A PREFERRED EMBODIMENT OF THE INVENTION

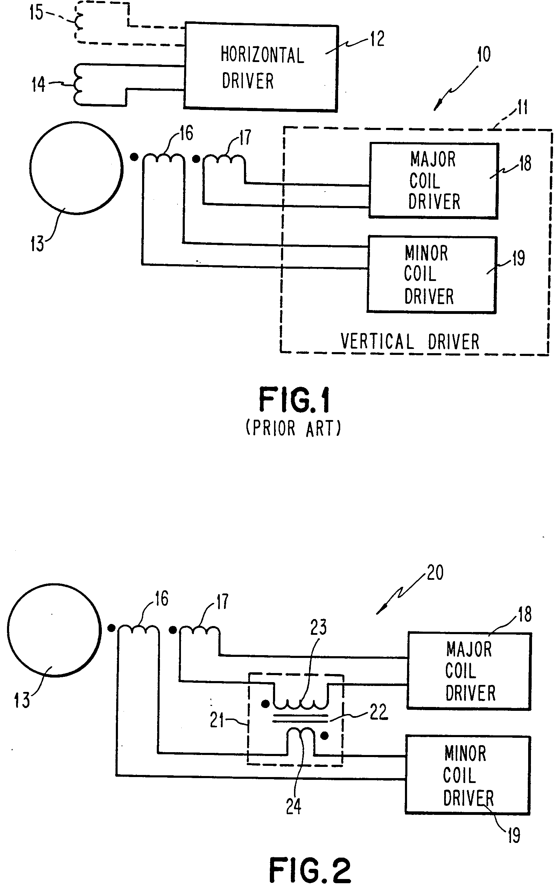

Referring now to the drawings, and more particularly to Figure 1, there is shown a schematic representation of a conventional multi-channel magnetic yoke and driving circuits therefor. As noted above, while these circuits may be hereinafter referred to in terms of "deflection" arrangements in the interest of clarity since such an application will be familiar to those skilled in the art, it is to be understood that such reference to a possible use is not intended to limit or infer limitation on the range of possible applicability of the invention for producing a magnetic field in area 13 which may be, for instance the neck of a cathode ray tube or a charged particle beam column such as the electron beam column of an electron beam lithography apparatus. The driving circuit includes at least driver circuit 11, arbitrarily designated as a vertical driver. The system may also include one or more magnetic coils 14, 15 or sets of such coils and drivers such as driver 12, arbitrarily designated as a horizontal driver. It will be sufficient for providing a full understanding of the invention to consider only one such deflection system such as that including coils 16, 17 and driver 11.

In a conventional arrangement, the driver circuitry will include a plurality of separate coil driver circuits such as major coil driver 18 and minor coil driver 19, each connected to a respective one of coils 16, 17. The polarity of mutual inductance of coils 16, 17 is indicated by dots annexed thereto.

As pointed out above, minor coil driver 19 will have a large bandwidth and a fast response time whereas major coil driver 18 will have a small bandwidth and slow response time. Therefore, disturbances induced in coil 16 by currents in coil 17 will be small and rapidly accommodated by minor coil driver 19. These disturbances can therefore be neglected. However, changes in current in coil 16 will typically be rapid, such as a step function. Therefore, the disturbance induced thereby in coil 17 will be large. Moreover, as pointed out above, the slow response time of major coil driver 18 and any filtration or other circuitry for limiting the bandwidth thereof for noise reduction will additionally reduce the ability of the circuit to recover from such a disturbance and the recovery or settling time will be long.

To correct for this deficiency of the prior art, the system 20 according to the invention, as illustrated in Figure 2, includes the same area 13, coils 16, 17 and major/minor coil drivers 18, 19. Compared with the prior art of Figure 1, the system according to the invention additionally includes a compensation means 21 for the purpose of coupling a voltage corresponding (e.g. generally proportional) to the changes in current in coil 16 to the major coil driving circuit. In this way, an unavoidable induced voltage need not result in an induced current in the major coil. As illustrated, compensation means 21 will preferably comprise a transformer which should be shielded or located a suitable distance from the coils 16, 17 and area 13 to provide isolation so that stray magnetic fields therefrom cannot affect any deflection of the beam or provide further mutual induction between coils 16, 17 and the transformer. It is also possible to simulate a passive transformer as a compensation means 21 in the above arrangement within the scope of the present invention. However, simulation of the transformer is not preferred because such a simulation would be more complex, less reliable and susceptible to errors and drift due to ambient conditions. The transformer having core 24, primary coil 22 and secondary coil 23 is preferably made adjustable in a manner which will be discussed below in order to be closely matched to the mutual inductance between coils 16 and 17 to be equal but opposite thereto. The inductance of the primary and secondary coils is preferably kept as low as possible to minimize effects on the bandwidth of the driver circuits. The voltage produced by compensation means 21 in response to changes in current in the minor coil driver circuit is preferably coupled into the major coil driver circuit by placing it in series with the major coil driver 18. As indicated by the dots on coils 16, 17, 22 and 23, the voltage produced by the compensation means 21 is coupled into the major coil driver circuit with the polarity thereof arranged to oppose the voltage or current induced in coil 17. If this is done and the transformer or other compensation means 21 is closely matched to the mutual inductance of coils 16 and 17, the induced voltage will be balanced by the voltage developed by the compensation means and an induced voltage disturbance will result in a minimal current disturbance. The deliberately introduced balancing disturbance effectively prevents the induced disturbance from being detected by the major coil driver and prevents the circuit from prolonging the disturbance due to its slow response and settling time. Of course, it would also be possible to sense the disturbance and correct it, but such an approach would be fundamentally different from the present invention since the basic concept of the invention is to avoid any significant current disturbance being seen by the major deflection driver. The effectiveness of the present invention in reducing settling time directly results from the prevention of the induced disturbance and the consequent attempted correction of the same by a driver circuit of low bandwidth.

With the deliberately introduced disturbance compensating for the unavoidable coupling between coils 16 and 17, it is possible to obtain a net disturbance with the wave form of a small and extremely narrow spike. When such a narrow spike reaches the major deflection driver, it will be integrated over many tens of microseconds, resulting in a negligible change in its output current and resultant change in major coil flux or charged particle beam displacement. The passive response of the major coil or yoke to the disturbance therefore settles very quickly to negligible amplitudes making the settling time of the major coil driver to a predetermined low current level comparable to or even less than the settling time of the minor coil driver to the same predetermined low voltage level. Accordingly, the settling time for beam positioning is limited by the minor coil driving system and the full throughput potential of a major/minor deflection system can be obtained.

In essence, the invention enables the effective modification of the net mutual inductance between any desired number of channels which have an unavoidable mutual inductance but should, theoretically, function independently. Since the compensation means 21 can be made to provide any voltage which may be required to balance an induced disturbance in coil 17, and can thus be matched to the mutual inductance between coils 16 and 17 regardless of their spacing, if any, the problems originating from mutual inductance of coils 16 and 17 can be remedied independently of the geometry of the multi-channel yoke and the coils therein. Therefore, as in the Variable Axis Immersion Lens (VAIL), multiple coils may be located in the same axial position along the particle beam column.

The above compensation technique and apparatus can be applied to any multi-channel magnetic field generating device and is particularly applicable to cathode ray tubes and electron lithography machines having multi-channel deflection yokes. The invention may be applied as many times as desired in the same device where slow and fast magnetic field changes interact in the same space, such as the coils corresponding to the two orthogonal deflection directions in such devices. Two-dimensional deflection systems could also employ the invention to compensate for small errors in the deflection coil winding patterns and to fine tune the orthogonality of deflections. The invention is thus also applicable to improve resolution in electron microscopes, ion beam writing systems (e.g. for mask repair and as a current probe for testing) and high precision or high resolution displays. For some specialized applications, it may be desirable to alter the balancing of the mutual inductance to deliberately skew the axes of deflection as in recording on a moving medium and application of the invention is not limited to applications where the deflection directions are orthogonal.

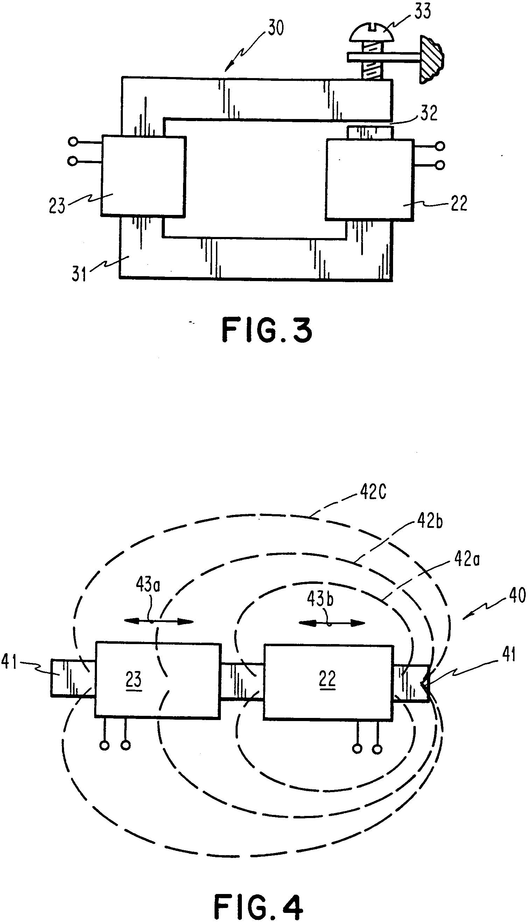

Referring now to Figure 3, a preferred form of the transformer constituting compensation means 21 is shown in a simplified form. This transformer is formed by two coils 22, 23, forming the primary and secondary windings, mounted on a ferrite core 31 having an air gap 32. The inductance of the transformer, in most cases, should preferably be minimized as noted above. Single or low numbers of turns in the primary and secondary windings are therefore preferable. The remainder of the aspects of the design of the transformer are well within the purview of those skilled in the art. An adjustment means 33, the form of which is unimportant to the practice of the invention, is provided for adjusting air gap 32. As is wellunderstood in the art, the amount of flux generated in a core by a given number of ampere turns of a primary winding will be proportional to the reluctance of the core. In this case, the reluctance of the core is almost solely determined by the length of the air gap. Therefore, the amount of magnetic flux in the core which will link the secondary winding can be fully and accurately controlled to adjust the voltage which is introduced into the major coil driver circuit to balance the induced voltage. In this embodiment, flux can also be adjusted or controlled by providing electrical control of the degree of saturation of the magnetic circuit by providing further windings on the core and passing, for example, a DC current therethrough.

Alternatively, as illustrated in Figure 4, a transformer 40 consisting of two air coils 22, 23, mounted on two bobbins, at least one of which can be made moveable with respect to the other can be used to adjust the amount of flux from the primary coil which will link the secondary coil, providing a similar degree of adjustability. In this embodiment, core 41 which is preferably of a ferromagnetic material does not form a magnetic circuit and the field from primary coil 22 will have the form indicated by flux lines 42a, 42b and 42c. If either or both of the coils are movable as indicated by arrows 43a and 43b, the amount of flux linking the secondary coil can be easily adjusted.

It should be noted that other methods and circuits for adjusting the flux in either of the above embodiments are known, such as providing a variable shunt on the primary winding. Since this invention is directed to correction of an effect due to the current in the minor coil, any flux adjusting arrangement which causes the input current to the compensation means 21 to differ from the minor coil current is unsuitable for use in the present invention.

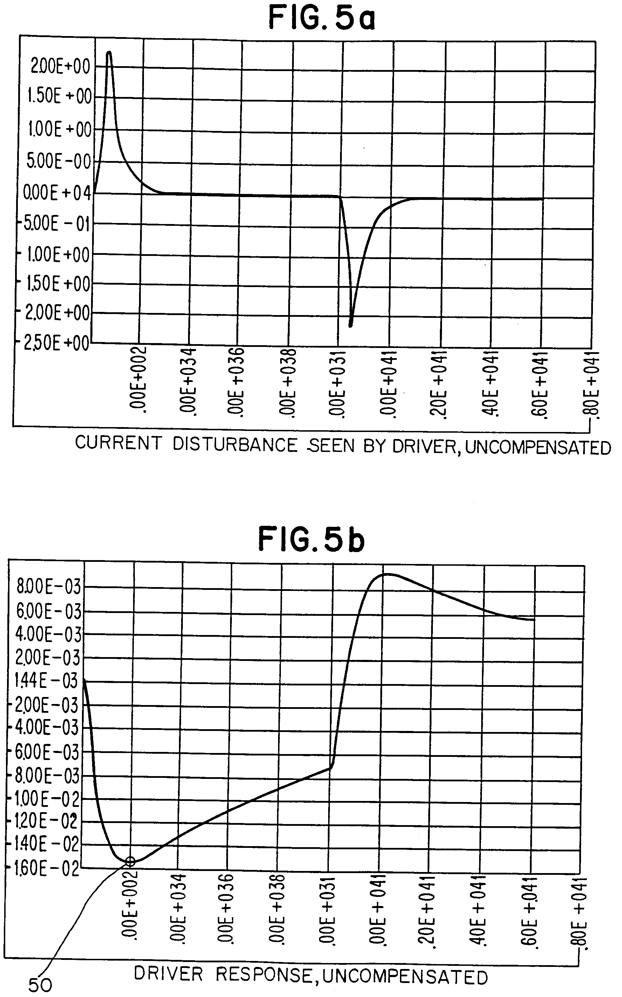

Referring now to Figure 5a and 5b, the current disturbance induced in the major coil by a square pulse applied to the minor coil and the major coil driver response thereto is illustrated for a conventional major/minor deflection multi-channel yoke. In Figure 5a, it is seen that the leading and trailing edges of a pulse comparable in width to a typical minor coil stepping time produce a pair of opposite pulses which rise rapidly and decay logarithmically. The slow response of the driver causes these pulses to be integrated over a period of time and the driver response is illustrated in Figure 5b. It is clearly seen that the major coil driver does not provide more than a negligible response to the disturbance until decay of the disturbance is substantially complete. More importantly, however, the response does not reach the intended value within the minor coil stepping time and clearly limits the throughput potentially available from the major/minor coil arrangement.

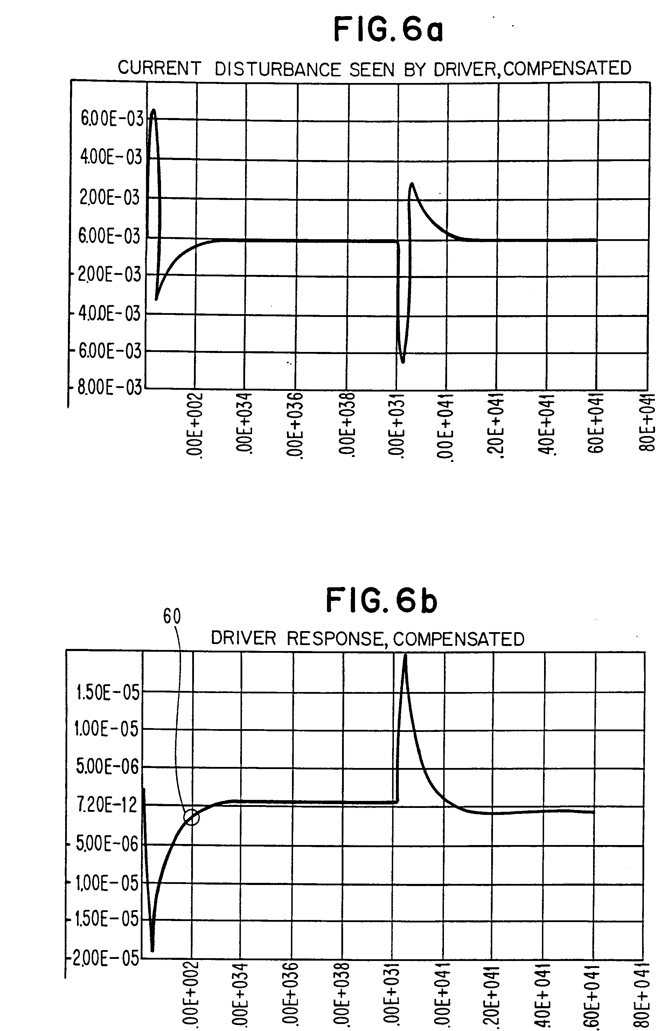

In Figure 6a and 6b, the effect of compensation provided by the invention is shown. In this case, as illustrated in Figure 6a, the current disturbance, since it is opposed by a voltage produced by compensation means 21, becomes a very narrow spike followed by a smaller, logarithmically decaying portion. The logarithmically decaying portion is inverted from the direction of the spike and the uncompensated case. It is important that the areas under the spike and the logarithmically decaying portion are substantially equal since, when the major coil driver integrates this disturbance over time. the integrated disturbance rapidly returns to zero, terminating the driver response thereto, as shown in Figure 6b. Thus, the desired current value in the major coil can be reached within a relatively small fraction of the minor coil stepping time.

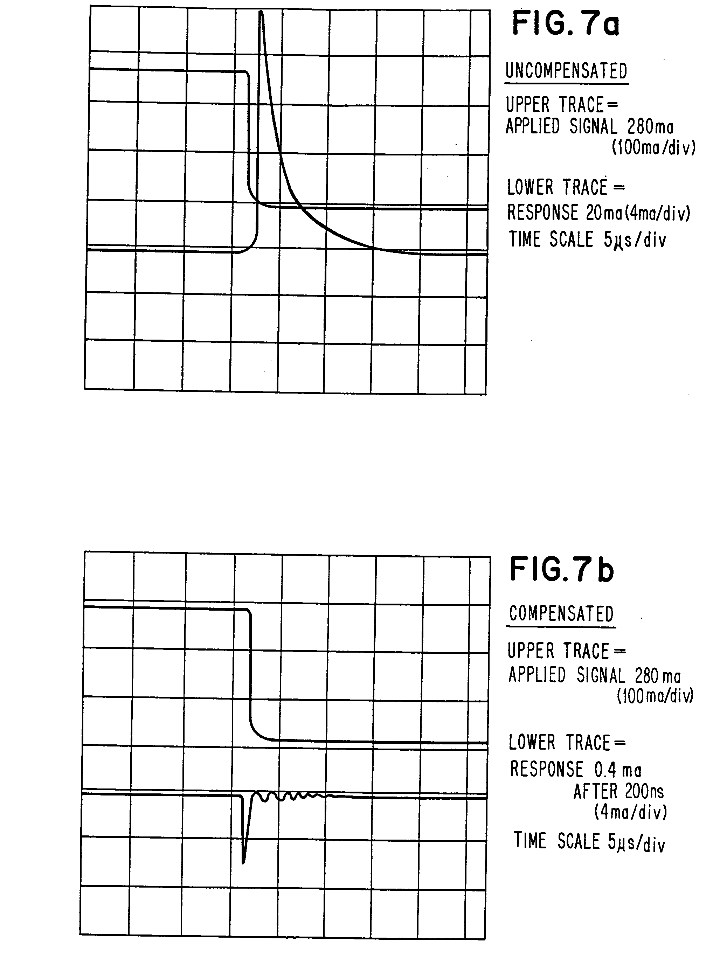

Referring now to Figures 7a and 7b, the efficacy of the invention to improve speed and accuracy of the production of a magnetic field or charged particle beam positioning is readily apparent. In the uncompensated case shown in Figure 7a, the upper trace shows the minor coil square current pulse of 280 ma. The induced current pulse of the major coil is comparable to that shown in Figure 5a, having a value of 20 ma. In the compensated case shown in Figure 7b, a similar square current pulse induces only a very narrow current spike in the major coil. After only 200 ns, this spike has settled to .4 ma. The ringing at slightly under 1 MHz is due to the time constant and resonance of the major yoke itself. The amplitude is extremely slight and of no practical significance.

Thus, it is seen that the present invention improves response speed by a factor of 300 (e.g. 200 ns as compared with 60 $\pi$s. If a 2 $\pi$s stepping time is chosen for the minor coil, the major coil current is reduced by a factor of 10,000 as illustrated by point 60 in Figure 6b as compared with point 50 in Figure 5b, confirming the efficacy of the invention to provide high speed and magnetic field accuracy for high particle beam positioning accuracy.

While the invention has been described in terms of a single preferred embodiment, those skilled in the art will recognize that the invention can be practiced with modification within the spirit and scope of the appended claims.

**Claims**

1. A method of producing a magnetic field having at least first and second co-directional components with a multi-channel yoke including first and second coils which are inductively coupled, said first and second coils having first and second currents passed therethrough, respectively, by respective first and second driver circuits, said method including the step of applying a voltage corresponding to a current in said second coil to said first coil, said voltage having a polarity for opposing current induced in said first coil by said second current in said second coil.

2. A method as recited in claim 1, wherein said applying step includes applying said voltage in series with said first driver circuit.

3. A method as recited in claim 1, including the further step of adjusting said voltage to approximately equal a second voltage induced on said first coil by said second current in said second coil.

4. A method as recited in claim 3, wherein said voltage is produced by a means including a transformer having primary and secondary windings and said adjusting step is performed by adjustment of the magnetic coupling between said primary and secondary coils.

5. A system for production of a magnetic field having at least first and second co-directional components including :
   a multi-channel yoke including first and second coils which are inductively coupled and positioned to produce said first and second co-directional components,
   first and second driver circuit means connected to said first and second coils for passing first and second currents through said first and second coils, respectively, and
   means for imposing a voltage component corresponding to said second current on said first coil, said voltage component having a polarity such that current induced in said first coil by said second current in said second coil is opposed.

6. A system as recited in claim 5, wherein said means for imposing a voltage component corresponding to said second current includes a transformer.

7. A system as recited in claim 6, wherein said transformer includes a core having an adjustable air gap.

8. A system as recited in claim 6, wherein said transformer includes a core upon which at least one of said first and second coils is positionally adjustable to adjust the magnetic coupling between said first and second coils.

9. A multichannel magnetic yoke including the system according to anyone of claims 5-8.

10. A cathode ray tube including the multichannel magnetic yoke according to claim 10.

11. An electron beam lithographic system including a multichannel yoke according to claim 10.

**FIG.1**
(PRIOR ART)

**FIG.2**

FIG.3

FIG.4

# FIG. 5a

CURRENT DISTURBANCE SEEN BY DRIVER, UNCOMPENSATED

# FIG. 5b

DRIVER RESPONSE, UNCOMPENSATED

50

# FIG.6a

## CURRENT DISTURBANCE SEEN BY DRIVER, COMPENSATED

# FIG.6b

## DRIVER RESPONSE, COMPENSATED

# FIG. 7a

UNCOMPENSATED

UPPER TRACE =
APPLIED SIGNAL 280ma
        (100ma/div)

LOWER TRACE =
RESPONSE 20ma(4ma/div)
TIME SCALE 5µs/div

# FIG. 7b

COMPENSATED

UPPER TRACE =
APPLIED SIGNAL 280 ma
        (100 ma/div)

LOWER TRACE =
RESPONSE 0.4 ma
        AFTER 200ns
        (4ma/div)
TIME SCALE 5µs/div